# EUROPÄISCHE PATENTSCHRIFT

(11) **EP 0 353 509 B1**
(45) Veröffentlichungstag und Bekanntmachung des Hinweises auf die Patenterteilung: **14.06.1995**
(21) Anmeldenummer: 89112778.9
(22) Anmeldetag: 12.07.1989
(51) Int. Cl.: H01L 27/144, H01L 31/103, H01L 31/107

(54) **Verfahren zur Herstellung einer integrierten Halbleiteranord- nung mit einem Photoelement und einem npn-Bipolartransistor in einem Siliziumsubstrat**
Method of fabricating an integrated semiconductor device comprising a photoelement and an npn-bipolar transistor in a silicon substrate
Procédé de fabrication d'un dispositif à semi-conducteur intégré comprenant un élément photosensible et un transistor bipolaire du type npn dans un substrat en silicium

(30) Priorität: 04.08.1988 DE 3826583
(43) Veröffentlichungstag der Anmeldung: 07.02.1990
(73) Patentinhaber: SIEMENS AKTIENGESELLSCHAFT, 80333 München (DE)
(72) Erfinder: Reisch, Michael, Dipl.-Phys., D-8201 Hohenthann (DE)

(56) Entgegenhaltungen:
- EP-A- 0 226 890
- PATENT ABSTRACTS OF JAPAN, Band 10, Nr. 356 (E-459)[2414], 29. November 1986 ; & JP-A-61 154 063
- S.M. SZE: "Physics of Semiconductor Devices", 2. Edition, Teil V, Photonic Devices, Kapitel 13, Photodetectors, 1981, Seiten 772-773, John Wiley & Sons, Inc., New York, US
- IBM TECHNICAL DISCLOSURE BULLETIN, Band 23, Nr. 8, Januar 1981, Seiten 3730-3731, New York, US; N.G. ANANTHA et al.: "Bipolar transistor having low base-collector junction and diffusion capacitances"
- NEW ELECTRONICS, Band 20, Nr. 17, 1. September 1987, Seiten 33-35, London, GB;D. COOK: "Light sensing with optical ICs"

## Beschreibung

Die Erfindung betrifft ein Verfahren zur Herstellung einer integrierten Halbleiteranordnung mit einem Fotoelement und einem npn-Bipolartransistor in einem Siliziumsubstrat.

Als Optokoppler für kurze und mittlere Entfernungen sowie für die Kommunikation zwischen Rechenanlagen sind Fotoelemente von Interesse, die monolithisch in Silizium-Chips integriert sind. An die verwendeten Fotoelemente wird dabei die Forderung gestellt, daß sie neben Prozeßkompatibilität mit der im Silizium-Chip vorhandenen Schaltung eine hohe Quantenausbeute und eine hohe Ansprechgeschwindigkeit aufweisen.

Es ist bekannt (siehe zum Beispiel H. J. Hindin, "Integration is on the Way for Fiber-Optic Receivers", Electronics, Oct. 1980, pp. 155 ... 160; R. W. Ade et. al., "Silicon Photodetector Structure for Direct Coupling of Optical Fibers to Integrated Circuits", IEEE Trans. El. Edv., Vol. ED-34, pp. 1283 ... 1289 (1987)), für die monolithische Integration von Fotoelementen in Silizium-Chips als Fotoelement die sogenannte Kollektor-Substrat-Diode zu verwenden, das heißt, die Diode, die aus dem Kollektor und dem Substrat gebildet wird. Kollektor-Substrat-Dioden weisen eine hohe Quantenausbeute auf. In der Kollektor-Substrat-Diode gelangen die erzeugten Minoritäten über Diffusion zum schwach vorgespannten Kollektor-Substrat-pn-Übergang. Wegen der hohen Minoritätsladungsträger-Lebensdauer im Substrat führt dieses zu großen Zeitkonstanten. Deshalb weisen Kollektor-Substrat-Dioden eine sehr geringe Ansprechgeschwindigkeit auf. Höhere Datenraten (größer 10 Mbit/s) können nicht verarbeitet werden.

Aus Patent Abstracts of Japan, Band 10, Nr. 356 (E-459) (2414) ist eine optische Halbleiteranordnung mit einem Fotoelement und einem npn-Bipolartransistor bekannt. Dabei ist auf einem p⁺-dotierten Substrat eine p-dotierte Epitaxieschicht aufgewachsen. Auf der p-dotierten Epitaxieschicht ist eine n-dotierte Epitaxieschicht angeordnet, in der der npn-Bipolartransistor realisiert ist. Der npn-Bipolartransistor umfaßt einen vergrabenen Kollektor, der an der Grenzfläche zwischen der n-dotierten und der p-dotierten Epitaxieschicht angeordnet ist. Das Fotoelement wird durch eine entsprechende Beschaltung des pn-Übergangs, der an der Grenzfläche zwischen der n-dotierten Epitaxieschicht und der p-dotierten Epitaxieschicht angeordnet ist, gebildet. Dieser pn-Übergang entspricht der Kollektor-Substrat-Diode des Bipolartransistors.

Der Erfindung liegt die Aufgabe zugrunde, ein Verfahren zur Herstellung einer in einem Siliziumsubstrat integrierten Halbleiteranordnung mit einem Fotoelement und einem npn-Bipolartransistor anzugeben, die für den Nachweis hoher Datenraten geeignet ist, wobei das Fotoelement neben hoher Quantenausbeute auch eine hohe Ansprechgeschwindigkeit aufweist. Insbesondere soll das Herstellverfahren mit dem Herstellprozeß des Bipolartransistors kompatibel sein.

Diese Aufgabe wird erfindungsgemäß gelöst durch ein Verfahren gemäß Anspruch 1. Weitere Ausgestaltungen der Erfindung gehen aus den übrigen Ansprüchen hervor.

Der lichtempfindliche Teil des Fotoelementes in der nach dem erfindungsgemäßen Verfahren hergestellten Anordnung wird durch den aus p-dotierter Schicht und n-dotiertem Gebiet erzeugten pn-Übergang gebildet. Auf diese Weise lassen sich in dem Substrat Fotoelemente, die der pin-Diode ähnlich sind, realisieren. Solche Fotoelemente haben neben hoher Quantenausbeute eine große Ansprechgeschwindigkeit. Der n-dotierte Schutzring verhindert Feldspitzen am Rand des Anschlusses des n-dotierten Gebietes.

Bei Verwendung eines Siliziumsubstrates, das vorzugsweise n⁺-dotiert ist, werden sogenannte "Diffusions-Schwänze" im Fotostrom abgeschnitten. Ferner wird dadurch ein hoher Dunkelstrom verhindert, der durch Diffusion von Minoritäten aus den Randbereichen zustandekommt (siehe zum Beispiel S. Cova et. al., "Epitaxial Silicon Avalanche Photodiodes for Single Photon Detection with Picosecond Resolution", ESSDERC ′87, Tech. Dig., pp. 1077 ... 1080).

Es ist vorteilhaft, die p-dotierte Schicht mit einem vertikalen Dotierungsprofil vorzusehen. Zur Reduktion des Anschlußwiderstandes über das Substrat folgt mindestens im Bereich unterhalb des Fotoelementes auf das Substrat eine p⁺-dotierte Zone. Diese p⁺-dotierte Zone kann in Form einer p⁺-dotierten Schicht über das gesamte Substrat ausgebildet sein.

Auf die p⁺-Zone folgt eine schwach p-dotierte Zone, die als Driftzone wirkt. Auch diese schwach p-dotierte Zone kann in Form einer schwach p-dotierten Schicht vorliegen. Im Bereich unterhalb der Bipolartransistoren ist eine p-dotierte Zone zur Optimierung der Kollektor-Kollektor-Isolation vorgesehen. Diese p-dotierte Zone wird vorzugsweise aus p-dotierten Wannen gebildet, die die bipolaren Schaltungsteile enthalten. Eine andere Möglichkeit ist es, die p-dotierte Zone durch eine p-dotierte Schicht, die über die gesamte Struktur verläuft, zu bilden.

Eine Avalanche-Zone wird in dem Fotoelement dadurch realisiert, daß zwischen dem p-dotierten Gebiet und dem n-dotierten Gebiet ein p⁺-dotierter Bereich vorgesehen wird. In der Avalanche-Zone wird die Ladungsträgerwolke verstärkt, was zu einer höheren Ansprechempfindlichkeit des Fotoelementes führt.

Die erfindungsgemäß hergestellte Anordnung ist zur optoelektronischen Kopplung elektronischer Schaltungen auf verschiedenen Silizium-Chips geeignet.

Die Verwendung einer p-dotierten Epitaxieschicht, in der der Emitter und der Kollektor durch Implantation von n-dotierenden Ionen erzeugt werden, ermöglicht die monolithische Integration schneller Fotoelemente mit npn-Bipolartransistoren. Zur Herstellung schneller Fotoelemente wird an der Oberfläche des Substrats ein p-dotiertes Material benötigt. Die Verfahrensschritte lassen sich gut in den Verfahrensablauf des "normalen" Bipolarprozeßes einfügen. Es wird lediglich eine zusätzliche Fototechnik benötigt für die Abschirmung des Fotoelementbereichs bei der Basis-implantation.

Eine Vereinfachung des Verfahrens ergibt sich, wenn der vergrabene Kollektor durch Implantation mit hochenergetischen, n-dotierenden Ionen erzeugt wird. Die Reichweite von n-dotierenden Ionen mit Energien größer einem Megaelektronenvolt in das p-dotierte Gebiet ist so groß, daß sich das Aufbringen der p-dotierten Epitaxieschicht erübrigt, weil oberhalb des vergrabenen Kollektors genug Material zum Aufbau des Bipolartransistors vorhanden ist (sogenannter Pseudo-Buried-Layer-Prozeß).

Weitere Ausgestaltungen der Erfindung ergeben sich aus den übrigen Ansprüchen.

Im folgenden wird die Erfindung anhand von Ausführungsbeispielen und anhand der Figuren näher erläutert.
- Figur 1: stellt eine erfindungsgemäß hergestellte Anordnung dar mit einem Fotoelement und einem Bipolartransistor.
- Figur 2: stellt eine erfindungsgemäß hergestellte Anordnung dar mit einem Fotoelement, das eine Avalanche-Zone aufweist, und einen Bipolartransistor dar.
- Figur 3: stellt eine erfindungsgemäß hergestellte Anordnung dar mit einem Fotoelement, bei dem der pn-Übergang in der schwach p-dotierten Schicht angeordnet ist, und einem Bipolartransistor, der in einer p-dotierten Wanne angeordnet ist.
- Figur 4: bis Figur 9 veranschaulichen den Ablauf des Herstellverfahrens.

In allen Figuren haben gleiche Bezugszeichen die gleiche Bedeutung.

### Figur 1:

Auf einem Siliziumsubstrat 1 ist eine p⁺-dotierte Schicht 21 angeordnet, die eine Dicke von etwa einigen »m hat. Auf der p⁺-dotierten Schicht 21 ist eine schwach p-dotierte Schicht 22 angeordnet, die eine Dicke von etwa 10 »m und eine Dotierung von etwa 10¹⁴cm⁻³ aufweist. Auf die schwach p-dotierte Schicht 22 ist eine p-dotierte Schicht 23 aufgebracht, die eine Dicke von etwa 5»m hat. Auf die p-dotierte Schicht 23 folgt eine p-dotierte Epitaxieschicht 5 mit einer Dicke von etwa 1 »m . Die p⁺-dotierte Schicht 21, die schwach p-dotierte Schicht 22, die p-dotierte Schicht 23 und die p-dotierte Epitaxieschicht 5 bilden gemeinsam das p-dotierte Gebiet 2.

In der p-dotierten Schicht 23 ist ein vergrabener Kollektor 3 angeordnet, der n-dotiert ist. Ebenso sind in der p-dotierten Schicht 23 Channel-Stopper-Bereiche 4 angeordnet, die ebenfalls n-dotiert sind und zur Trennung zwischen benachbarten Transistoren dienen. In der p-dotierten Epitaxieschicht 5 trennen Feldoxidbereiche 6 die aktiven Bereiche des Transistors sowie des Fotoelements. In der p-dotierten Epitaxieschicht 5 sind ebenfalls ein tiefreichender Kollektoranschluß 24, der n-dotiert ist, der Kollektor 11, der n-dotiert ist, die Basis 12, die p-dotiert ist, sowie der Emitter 13, der n-dotiert ist, angeordnet. Außerdem sind im Bereich des Fotoelementes ein n-dotiertes Gebiet 19 angeordnet sowie ein Schutzring 20, der das n-dotierte Gebiet 19 ringförmig umgibt. Auf die Oberfläche der so hergestellten Anordnung ist eine p⁺-dotierte Polysiliziumschicht 7 aufgebracht, die so strukturiert ist, daß sie als Basisanschlußbereich 9 sowie als Anschlußbereich 10 für das p-dotierte Gebiet des Fotoelements verwendet wird. Auf der Oberfläche der Anordnung befindet sich ferner eine n⁺-dotierte Polysiliziumschicht 14, die so strukturiert wird, daß sie als Emitteranschlußbereich 16, als Kollektoranschlußbereich 17 und als Anschlußbereich 18 für das n-dotierte Gebiet des Fotoelementes dient. Der Basisanschlußbereich 9 ist mit einer Oxidschicht 8 sowie mit Flankenisolationen 15 versehen. Die gesamte Anordnung ist mit einem Zwischenoxid 25 bedeckt. Im Zwischenoxid 25 sind für alle Anschlüsse Kontaktlöcher bis auf die Polysiliziumschichten geöffnet. Der Bipolartransistor ist mit einem metallischen Basiskontakt B, einem metallischen Emitterkontakt E und einem metallischen Kollektorkontakt K versehen.

### Figur 2:

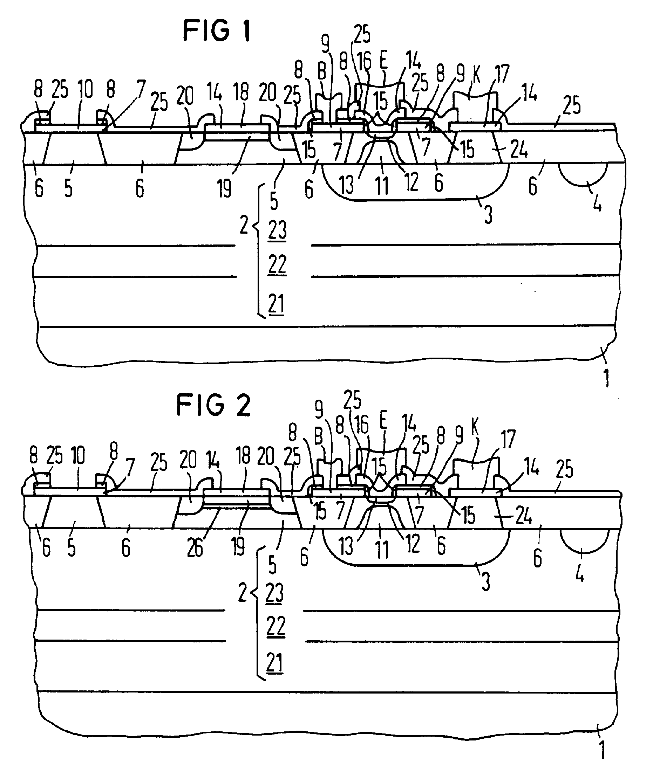

Es ist eine Anordnung dargestellt, die sich von der anhand Figur 1 erläuterten dadurch unterscheidet, daß das Fotoelement eine Avalanche-Zone (26) aufweist. Der Bipolartransistor ist genauso wie derjenige in Figur 1 aufgebaut. Das Fotoelement unterscheidet sich von dem Fotoelement der Figur 1 dadurch, daß in dem p-dotierten Gebiet 2 an der Grenzfläche zum n-dotierten Gebiet 19 ein p⁺-dotierter Bereich 26 angeordnet ist. Dieser p⁺-dotierte Bereich 26 führt dazu, daß es zu einer Beschleunigung der Ladungsträger und zu einer Verstärkung der Ladungsträgerwolke durch Lawinenbildung kommt. Dieser sogenannte Avalanche-Prozeß wird hier von Elektronen eingeleitet, was sich günstig auf das Rauschverhalten auswirkt.

### Figur 3:

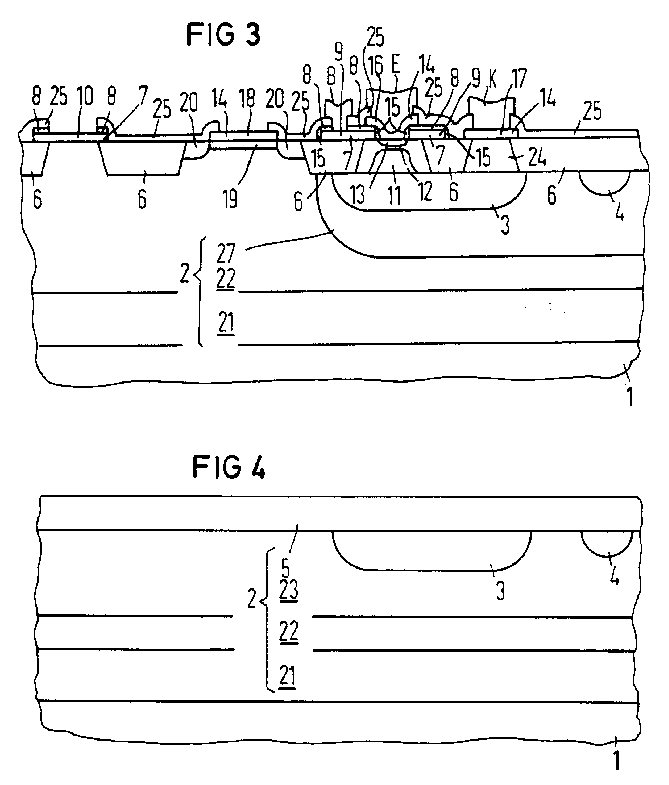

Für die Verarmung der schwach p-dotierten Schicht 22 (siehe Figur 1 und Figur 2) ist wegen der darüber befindlichen p-dotierten Schicht 23 eine Spannung von mehreren 10 Volt erforderlich. In Anwendungen, in denen niedrige Versorgungsspannungen gefordert werden, kann eine Anordnung wie sie in Figur 3 dargestellt ist, verwendet werden. In dieser Anordnung in Figur 3 reicht die schwach p-dotierte Schicht 22 im Bereich des Fotoelementes bis an das n-dotierte Gebiet 19 und den Schutzring 20 heran. Um eine gute Kollektor-Kollektor-Isolation des Bipolartransistors zu gewährleisten, ist der Bipolartransistor in einer p-dotierten Wanne 27 aufgebaut. Auf diese Weise wird die zur Verarmung erforderliche Sperrschichtspannung des Fotoelementes drastisch reduziert. Die p-dotierte Wanne wird nach einer Fototechnik in die schwach p-dotierte Schicht 22 implantiert.

Im folgenden wird das Herstellverfahren anhand von Figuren näher erläutert. Die Herstellschritte zur Herstellung des Bipolartransistors sind zum Beispiel aus EP 0 226 890 A1 bekannt.

### Figur 4:

Die dargestellte Struktur wird durch folgende Schritte gewonnen. Auf das n-dotierte Substrat 1 wird die p⁺-dotierte Schicht 21, darauf die schwach p-dotierte Schicht 22 und darauf die p-dotierte Schicht 23 aufgewachsen. In die p-dotierte Schicht 23 wird nach einer Fototechnik durch Implantation der vergrabene Kollektor 3 erzeugt. Der vergrabene Kollektor 3 wird durch Implantation mit n-dotierenden Ionen, zum Beispiel mit Antimon erzeugt. Nach einer weiteren Fototechnik werden die Channel-Stopper-Bereiche durch Implantation mit n-dotierenden Ionen, zum Beispiel mit Bor erzeugt. Die Channel-Stopper-Bereiche 4 sorgen für eine sichere Isolation zwischen benachbarten Kollektorgebieten. Auf die Oberfläche der p-dotierten Schicht 23 mit dem vergrabenen Kollektor 3 und dem Channel-Stopper-Bereich 4 wird die p-dotierte Epitaxieschicht 5 aufgewachsen. Die p⁺-dotierte Schicht 21, die schwach p-dotierte Schicht 22, die p-dotierte Schicht 23 und die p-dotierte Epitaxieschicht 5 bilden zusammen das p-dotierte Gebiet 2. Im herkömmlichen Bipolarprozeß wird anstelle der p-dotierten Epitaxieschicht 5 eine n-dotierte Epitaxieschicht aufgewachsen.

### Figur 5:

Mit einer LOCOS-Technik werden in der p-dotierten Epitaxieschicht 5 die Feldoxidbereiche 6 erzeugt, die zur Trennung der aktiven Transistorbereiche und zur Trennung des Fotoelements erforderlich sind. Auf der Oberfläche der p-dotierten Epitaxieschicht 5 wird ganzflächig eine p⁺-dotierte Polysiliziumschicht 7 erzeugt. Auf die p⁺-dotierte Polysiliziumschicht 7 wird eine Oxidschicht 8 aufgebracht.

### Figur 6:

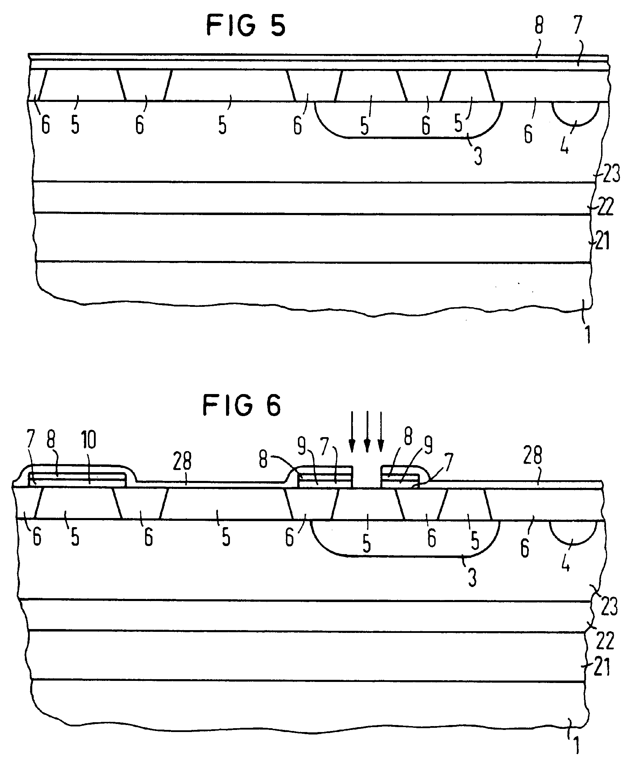

Nach einer Fototechnik werden die p⁺-dotierte Polysiliziumschicht 7 und die Oxidschicht 8 durch Ätzen so strukturiert, daß der Anschlußbereich 10 für das p-dotierte Gebiet des Fotoelements und der Basisanschlußbereich 9 definiert werden. Die Struktur wird mit einer Maske 28 versehen, die bei der nachfolgenden Implantation des Kollektors 11 und der Basis 12 die Bereiche außerhalb des aktiven Transistors abschirmt. Die Implantation ist in Figur 6 als Pfeile angedeutet.

### Figur 7:

Der Kollektor 11 wird durch Implantation mit n-dotierenden Ionen, zum Beispiel mit Phosphor, erzeugt. Das Gebiet der p-dotierten Epitaxieschicht 5, in das der Kollektor 11 implantiert wird, wird durch den aus der p⁺-dotierten Polysiliziumschicht 7 bestehenden Basisanschlußbereich 9 definiert. Im nächsten Schritt wird mit derselben Maske die Basis 12 durch Implantation mit p-dotierenden Ionen (zum Beispiel Bor) erzeugt.

Nach dem Entfernen der Maske 28 werden an den Flanken der strukturierten p⁺-dotierten Polysiliziumschicht 7 im Bereich des Basisanschlußbereichs 9 Flankenisolationen 15 erzeugt.

Nach einer weiteren Fototechnik wird der Kollektoranschluß 24 durch Implantation mit n-dotierenden Ionen (zum Beispiel Arsen) hergestellt.

Auf der Struktur wird ganzflächig eine n⁺-dotierte Polysiliziumschicht 14 erzeugt.

### Figur 8:

Die n⁺-dotierte Polysiliziumschicht 14 wird im folgenden so strukturiert, daß der Emitteranschlußbereich 16, der Kollektoranschlußbereich 17 sowie der Anschlußbereich 18 für das n-dotierte Gebiet 19 des Fotoelements definiert werden.

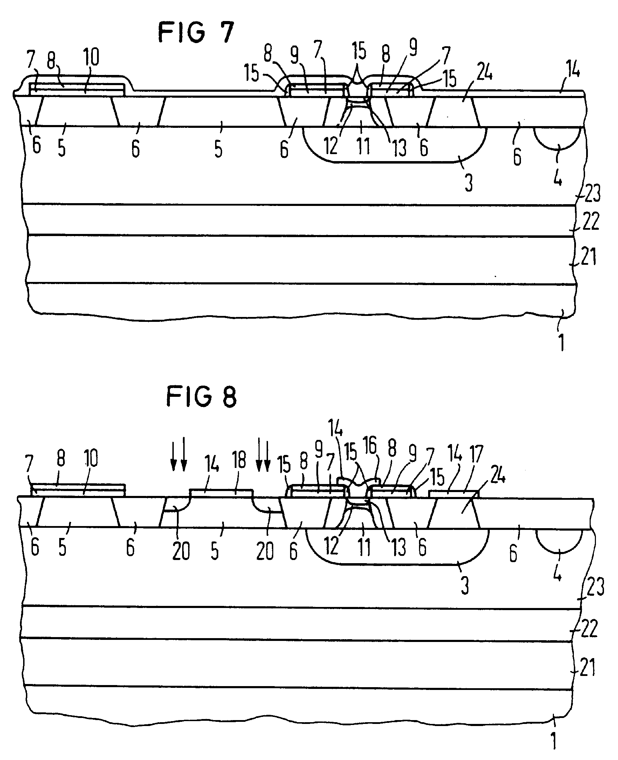

Nach Maskierung der übrigen Bereiche (nicht dargestellt) wird durch Implantation mit n-dotierenden Ionen der Schutzring 20 um den Anschlußbereich 18 für das n-dotierte Gebiet des Fotoelementes herum hergestellt. Bei der Implantation, in Figur 8 als Pfeile angedeutet, wirkt der Anschlußbereich 18 für das n-dotierte Gebiet des Fotoelements als Implantationsmaske. Der Schutzring 20 ist erforderlich, um Feldspitzen an dem aus der n⁺-dotierten Polysiliziumschicht 14 bestehenden Anschlußbereich 18 für das n-dotierte Gebiet des Fotoelements zu verhindern.

### Figur 9:

In einem Hochtemperaturschritt werden die Dotierstoffe aus der p⁺-dotierten Polysiliziumschicht 7 und aus der n⁺-dotierten Polysiliziumschicht 14 in die jeweils darunterliegenden Bereiche der Epitaxieschicht eindiffundiert. Dabei wird das n-dotierte Gebiet 19 gebildet. Im nächsten Schritt wird auf der Struktur ganzflächig das Zwischenoxid 25 abgeschieden.

Nach dem Öffnen der Kontaktlöcher für alle Anschlußbereiche so wie der Metallisierung des Basiskontakts B, des Emitterkontakts E, sowie des Kollektorkontaktesk nach bekannten Prozeßschritten ergibt sich die in Figur 1 dargestellte Struktur.

Zum Herstellen einer Anordnung mit einem Fotoelement mit Avalanche-Zone wird nach der Basisimplantation im Bereich, in dem später das n-dotierte Gebiet 19 erzeugt wird, eine Implantation mit p-dotierenden Ionen (zum Beispiel Bor, Energie: 10 keV) vorgenommen.

Durch die Verwendung der p-dotierten Epitaxieschicht 5, in der durch Implantation mit n-dotierenden Ionen der Kollektor 11, der Kollektoranschluß 24 und der Emitter 13 gebildet werden, wird das Einfügen der Herstellung eines der pin-Diode ähnlichen Fotoelementes mit oder ohne verstärkender Avalanche-Zone in den Bipolarprozeß ermöglicht. Auf diese Weise lassen sich Fotoelemente mit hoher Quantenausbeute und großer Ansprechgeschwindigkeit in das bestehende Siliziumbipolarkonzept integrieren. Durch die monolithische Integration von Fotoelementen hoher Empfindlichkeit und Ansprechgeschwindigkeit in Silizium-chips wird die Einkopplung optischer Signale mit hohen Datenraten direkt auf dem Chip ermöglicht.

Bei der Herstellung einer Anordnung mit einem Fotoelement mit niedriger Versorgungsspannung, wie sie in Figur 3 dargestellt ist, wird nach der Abscheidung der schwach p-dotierten Schicht 22 nach einer Fototechnik die p-dotierte Wanne 27 durch Implantation mit p-dotierenden Ionen (zum Beispiel mit Bor) hergestellt. Der Verfahrensschritt, in dem die p-dotierte Epitaxieschicht 5 erzeugt wird, entfällt, da der Bipolartransistor in der p-dotierten Wanne 27 aufgebaut wird. Die übrigen Verfahrensschritte verlaufen analog dem oben Geschilderten.

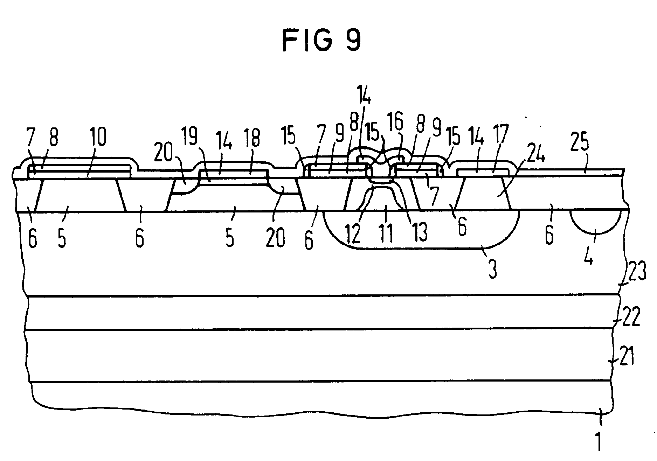

Eine Variante des anhand der Figuren 4 bis 9 geschilderten Verfahrens besteht darin, den vergrabenen Kollektor 3 sowie die Channel-Stopper-Bereich 4 in einem sogenannten Pseudo-Buried-Layer-Prozeß herzustellen. Dabei wird die Implantation mit Ionen großer Reichweite, das ist gleichbedeutend mit großer Energie, tief in die p-dotierte Schicht 23 implantiert. Oberhalb des vergrabenen Kollektors 3 sowie der Channel-Stopper-Bereiche 4 bleibt eine Schicht der p-dotierten Schicht 23 übrig, in der die Strukturen erzeugt werden können, die nach dem oben Geschilderten in der p-dotierten Epitaxieschicht 5 hergestellt werden. Bei einer genügend großen Dicke der p-dotierten Schicht 23 und einer Energie der n-dotierenden Ionen von etwa 1 MeV kann die p-dotierte Epitaxieschicht 5 entfallen. In dieser Verfahrensvariante werden der Kollektor 11, der Emitter 13, der Kollektoranschluß 24 durch Implantation mit n-dotierenden Ionen in der p-dotierten Schicht erzeugt. Es wird ein Verfahrensschritt eingespart.

## Patentansprüche

1. Verfahren zur Herstellung einer integrierten Haibleiteranordnung mit einem Photoelement und einem npn-Bipolartransistor in eimem Siliziumsubstrat (1),
- bei dem auf dem Siliziumsubstrat (1), das n-dotiert ist, ganzflächig eine p-dotierte Schicht 21,22,23 bzw. 21,22,27 durch Aufwachsen erzeugt wird,
- bei dem in der p-dotierten Schicht 21,22,23 bzw. 21,22,27 durch Implantation mit n-dotierenden Ionen ein vergrabener Kollektor (3) erzeugt wird,
- bei dem in der p-dotierten Schicht 21,22,23 bzw. 21,22,27 durch Implantation mit n-dotierenden Ionen Channel Stopper-Bereiche (4) und auschließend an der Oberfläche Feldoxidbereiche (6) zur Trennung der aktiven Transistorbereiche und zur Trennung des Photoelementes erzeugt werden,
- bei dem ganzflächig eine p⁺-dotierte Polysiliziumschicht (7) und eine Oxidschicht (8) aufgebracht und durch Ätzen so strukturiert werden, daß unter den verbliebenen Schichtteilen ein Anschlußbereich (10) für ein p-dotiertes Gebiet des Photoelements und ein Basisanschlußbereich (9) definiert werden,
- bei dem die Struktur anschließend mit einer Maske (28) versehen wird, die bei der nachfolgenden Implantation des Kollektors und der Basis die Bereiche außerhalb des aktiven Transistors abschirmt,
- bei dem durch Implementation mit n-dotierenden Ionen ein Kollektor (11) gebildet wird, dessen Ausdehnung durch den Basisansclußbereich (9) definiert wird.
- bei dem durch Implantation mit p-dotierenden Ionen unter Verwendung derselben Maske (28) eine Basis (12) gebildet wird,
- bei dem nach Entfernen der Maske (28) im Bereich des Basisanschlußbereichs (9) Flankenisolationen (15) erzeugt werden,
- bei dem durch Implantation unter Verwendung einer weiteren Photolackmaske seitlich von Kollektor (11) und Basis (12) ein auf den vergrabenen Kollektor (3) reichender Kollektoranschluß (24) gebildet wird,
- bei dem ganzflächig eine n⁺-dotierte Polysiliziumschicht erzeugt und so strukturiert wird, daß unter den verbliebenen Schichtteilen ein Emitteranschlußbereich (16), ein Kollektoranschlußbereich (17) und ein Anschlußbereich (18) für ein n-dotiertes Gebiet des Photoelementes definiert werden,
- bei dem nach Maskierung der übrigen Bereiche durch Implantation mit n-dotierenden Ionen ein Schutzring (20) um den Anschlußbereich (18) hergestellt wird, wobei der Anschlußbereich (18) als Implantationsmaske verwendet wird,
- bei dem ein Temperschritt zur Ausdiffusion von Dotierstoffen aus den verbliebenen Teilen der n⁺-dotierten Polysiliziumschicht und der p⁺-dotierten Polysiliziumschicht durchgeführt wird bei dem das n-dotierte Gebiet (19) des Photoelements gebildet wird,
- bei dem ganzflächig ein Zwischenoxid (25) abgeschieden wird, in dem Kontaktlöcher zu den Anschlußbereichen geöffnet und mit Metallisierungen versehen werden.

2. Verfahren nach Anspruch 1,
- bei dem die p-dotierte Schicht (21,22,23) zusammengesetzt aufgebracht wird, wobei zunächst eine p⁺-dotierte Schicht (21), darauf eine schwach p-dotierte Schicht (22) und darauf eine p-dotierte Schicht (23) durch Aufwachsen erzeugt wird,
- bei dem nach Bildung des vergrabenen Kollektors (3) und der Channel-Stopper-Bereiche (4) ganzflächig eine p-dotierte Epitaxieschicht (5) aufgebracht wird.

3. Verfahren nach Anspruch 1 oder 2,
bei dem die Feldoxidbereiche (6) durch einen LOCOS-Prozeß gebildet werden.

4. Verfahren nach einem der Ansprüche 1 bis 3,
bei dem zur Herstellung einer Avalanche-Zone (26) nach der Basisimplantation in dem Bereich, in dem später das n-dotierte Gebiet (19) des Photoelementes erzeugt wird, mit entsprechender Maskierung einer Implantation mit p-dotierenden Ionen vorgenommen wird.

## Claims

1. Method for the production of an integrated semiconductor arrangement having a photoelement and an npn-bipolar transistor in a silicon substrate (1),
- in the case of which a p-doped layer (21,22,23 or 21,22,27) is produced by being grown on the silicon substrate (1) which is n-doped,
- in the case of which a buried collector (3) is produced in the p-doped layer (21,22,23 or 21,22,27) by implantation with n-doped ions,
- in the case of which channel stopper regions (4) and, subsequently, field oxide regions (6) on the surface are produced in the p-doped layer (21,22,23 or 21,22,27) by implantation with n-doped ions, in order to isolate the active transistor regions and in order to isolate the photoelement,
- in the case of which a p⁺-doped polysilicon layer (7) and an oxide layer (8) are deposited over the entire area and are structured by etching such that a connection region (10) for a p-doped area of the photo element, and a base connection region (9) are defined among the remaining layer parts,
- in the case of which the structure is then provided with a mask (28) which screens the regions outside the active transistor during the subsequent implantation of the collector and of the base,
- in the case of which a collector (11) is formed by implantation with n-doped ions, the extent of which collector (11) is defined by the base connection region (9),
- in the case of which a base (12) is formed by implantation with p-doped using the same mask (28),
- in the case of which flank insulations (15) are produced after removal of the mask (28) in the region of the base connection region (9),
- in the case of which a collector connection (24), which extends on the buried collector (3), is formed to the side of the collector (11) and the base (12), by implantation using a further photoresist mask,
- in the case of which an n⁺-doped polysilicon layer is produced over the entire area and is structured such that an emitter connection region (16), a collector connection region (17) and a connection region (18) for an n-doped area of the photoelement are defined among the remaining layer parts,
- in the case of which a protection ring (20) is produced around the connection region (18) by implantation with n-doped ions, after masking the other regions, the connection region (18) being used as an implantation mask,
- in the case of which a tempering step is carried out in order to diffuse dopants out of the remaining parts of the n⁺-doped polysilicon layer and the p⁺-doped polysilicon layer, during which the n-doped area (19) of the photoelement is formed,
- in the case of which an intermediate oxide (25) is deposited over the entire area, in which intermediate oxide (25) contact holes are opened to the connection regions and are provided with metallizations.

2. Method according to Claim 1,
- in the case of which the p-doped layer (21,22,23) is deposited in composed form, a p⁺-doped layer (21) initially being produced, a weakly p-doped layer (22) being produced thereon, and a p-doped layer (23) being produced thereon, by being grown,
- in the case of which a p-doped epitaxial layer (5) is deposited over the entire area after forming the buried collector (3) and the channel stopper regions (4).

3. Method according to Claim 1 or 2, in which the field oxide regions (6) are formed by a LOCOS process.

4. Method according to one of Claims 1 to 3, in the case of which an implantation with p-doped ions is carried out with suitable masking in order to produce an avalanche zone (26), after the base implantation in the region in which the n-doped area (19) of the photoelement is subsequently produced.

## Revendications

1. Procédé de fabrication d'un dispositif à semi-conducteur intégré comprenant un élément photosensible et un transistor bipolaire du type NPN dans un substrat en silicium (1),
- dans lequel, sur le substrat en silicium (1) à dopage de type N, on forme, sur toute la surface, par croissance, une couche à dopage de type P (21, 22, 23, respectivement 21, 22, 27),
- dans lequel, dans la couche à dopage de type P (21, 22, 23, respectivement 21, 22, 27), par implantation avec des ions procurant un dopage de type N, on crée un collecteur enfoui (3),
- dans lequel, dans la couche à dopage de type P (21, 22, 23, respectivement 21, 22, 27), par implantation avec des ions procurant un dopage de type N, on crée des régions d'interruption de canaux (4) et ensuite, sur la surface, des régions d'oxydes de champs (6) pour la séparation des régions de transistor actives et pour la séparation de l'élément photosensible,
- dans lequel on applique, sur toute la surface, une couche de polysilicium (7) à dopage de type P⁺ et une couche d'oxyde (8), et on les structure par gravure chimique de telle sorte que, parmi les parties restantes de la couche, sont définies une région de raccord (10) pour un domaine à dopage de type P de l'élément photosensible et une région de raccord de base (9),
- dans lequel on munit ultérieurement la structure d'un masque (28) qui, lors de l'implantation ultérieure du collecteur et de la base, protège les régions en dehors du transistor actif,
- dans lequel, par implantation avec des ions procurant un dopage de type N, on forme un collecteur (11) dont l'étendue est définie par la région de raccord de base (9),
- dans lequel, par implantation avec des ions procurant un dopage de type P, en utilisant le même masque (28), on forme une base (12),
- dans lequel, après élimination du masque (28), dans la zone de la région de raccord de base (9), on crée des isolations de flancs (15),
- dans lequel, par implantation, en utilisant un photorésist supplémentaire, on forme, à côté du collecteur (11) et de la base (12), un raccord de collecteur (24) aboutissant au collecteur enfoui (3),
- dans lequel on crée, sur toute la surface, une couche de polysilicium à dopage de type N⁺ et on la structure de telle sorte que parmi les parties restantes de la couche, sont définies une région de raccord d'émetteur (16), une région de raccord de collecteur (17) et une région de raccord (18) pour un domaine à dopage de type N de l'élément photosensible,
- dans lequel, après le masquage des autres régions par implantation avec des ions procurant un dopage de type N, on forme un anneau de protection (20) autour de la région de raccord (18), en utilisant la région de raccord (18) comme masque d'implantation,
- dans lequel on réalise une étape de recuit pour l'exo-diffusion de matières de dopage hors des parties restantes de la couche de polysilicium à dopage de type N⁺ et de la couche de polysilicium à dopage de type P⁺, dans laquelle on forme le domaine (19) à dopage de type N de l'élément photosensible,
- dans lequel, sur toute la surface, on précipite un oxyde intermédiaire (25) dans lequel on pratique des trous de contact donnant accès aux régions de raccord, et on les pourvoit d'une métallisation.

2. Procédé selon la revendication 1,
- dans lequel la couche (21, 22, 23) à dopage de type P est appliquée à l'état composé en créant, par croissance, d'abord une couche (21) à dopage de type P⁺, sur celle-ci une couche (22) à faible dopage de type P, et sur cette dernière une couche (23) à dopage de type P,
- dans lequel, après formation du collecteur enfoui (3) et des régions d'interruption de canaux (4), on applique, sur toute la surface, une couche épitaxiale (5) à dopage de type P.

3. Procédé selon la revendication 1 ou 2, dans lequel on forme les régions d'oxydes de champs (6) par un procédé LOCOS.

4. Procédé selon l'une quelconque des revendications 1 à 3, dans lequel, pour la fabrication d'une zone à avalanche (26) après l'implantation de la base dans la région dans laquelle on crée ultérieurement le domaine (19) à dopage de type N de l'élément photosensible, on procède, avec un masquage correspondant, à une implantation avec des ions procurant un dopage de type P.
